# FASCICULE DE BREVET EUROPEEN

(11) **EP 4 214 079 B1**
(45) Date de publication et mention de la délivrance du brevet: **09.07.2025**
(21) Numéro de dépôt: 21778449.5
(22) Date de dépôt: 17.09.2021
(51) Int. Cl.: B60K 35/00, B60K 35/10, B60K 35/22, B60K 35/50, B60K 35/60

(54) **DISPOSITIF D'AFFICHAGE**
ANZEIGEGERÄT
DISPLAY DEVICE

(30) Priorité: 18.09.2020 FR 2009496
(43) Date de publication de la demande: 26.07.2023
(73) Titulaire: Valeo Comfort and Driving Assistance, 94000 Créteil (FR)
(72) Inventeur: IRZYK, Michael, 94000 Créteil (FR); KORCZAK, Stephane, 94000 Créteil (FR); NOLL, Regis, 94000 Créteil (FR); DANGUILLAUME, Perig, 94000 Créteil (FR)
(74) Mandataire: Delplanque, Arnaud
(86) Numéro de dépôt international: PCT/EP2021/075720
(87) Numéro de publication internationale: WO 2022/058564

(56) Documents cités:
- WO-A1-2016/031533
- DE-T5- 112018 001 767
- FR-A1- 2 982 204
- US-A1- 2017 127 112

## Description

La présente invention concerne le domaine technique de l'affichage, en particulier dans les véhicules automobiles.

La présente invention concerne en particulier un dispositif d'affichage comprenant un afficheur, une plaque au moins partiellement transparente et une pièce de structure.

De tels dispositifs d'affichage sont notamment utilisés dans les véhicules automobiles pour afficher des informations destinées au conducteur du véhicule automobile ou aux passagers de ce véhicule automobile.

La plaque, réalisée par exemple en verre, peut recouvrir le dispositif d'affichage sur toute sa façade, ce qui confère un aspect esthétique au dispositif d'affichage.

La pièce de structure permet d'améliorer la tenue mécanique de l'ensemble. Ceci est intéressant en particulier lorsque la plaque présente une courbure, auquel cas la pièce de structure est conformée pour maintenir la plaque avec la courbure désirée.

WO 2016/031533 A1 divulgue un dispositif d'affichage pour un véhicule selon l'état de l'art.

Dans ce contexte, l'invention propose un dispositif d'affichage comprenant un afficheur, une plaque au moins partiellement transparente et une pièce de structure comprenant une partie arrière (ou socle) et une partie avant s'étendant vers la plaque à partir de la partie arrière en encadrant l'afficheur, la partie avant présentant une face avant s'étendant à une distance constante d'une face arrière de la plaque de manière à former une surface d'appui pour la plaque, caractérisé en ce que la partie avant présente au moins un évidement agencé pour former un passage entre la partie arrière et la plaque.

Un tel évidement permet l'implémentation de fonctionnalités supplémentaires à cet endroit, tel que le passage d'un câble électrique ou la définition d'une zone de fixation, sans génération d'un encombrement supplémentaire.

Par exemple, un câble électrique relié à l'afficheur peut être agencé dans le passage de manière à traverser ainsi la cloison de la pièce de structure.

Dans ce cas, un espace résiduel de l'évidement peut être rempli de colle. Dans certains modes de réalisation, de la colle peut alors s'étendre par endroits entre la partie arrière et la plaque, et/ou, au niveau du câble électrique, entre le câble électrique et la plaque.

Selon une autre possibilité, l'évidement peut accueillir au moins un élément (par exemple un téton) de coopération avec une patte de fixation d'une pièce supplémentaire (telle qu'une pièce de maintien d'un élément de l'afficheur ou une pièce de décor rapportée sur la pièce de structure).

La partie avant peut comporter une pluralité d'évidements distincts (c'est-à-dire séparés par des régions de la partie avant) formant (chacun) un passage entre la partie arrière et la plaque. Ainsi, certains de ces évidements peuvent être utilisés pour la passage de câble, comme proposé ci-dessus, tandis que d'autres évidements peuvent être utilisés pour participer à la fixation d'une pièce, comme également proposé ci-dessus.

En pratique, la plaque peut être courbe. La pièce de structure a un intérêt particulier dans ce cas. On peut d'ailleurs prévoir alors que la face avant soit inscrite dans un cylindre, par exemple un cylindre d'axe perpendiculaire à une normale à la surface d'affichage et, dans les exemples présentés dans la suite, perpendiculaire à la plus grande direction d'extension de la plaque. En variante, la plaque peut être plane.

Selon une possibilité de réalisation, le passage étant défini par une paroi latérale orthogonale à la face avant, la partie avant peut présenter une surface de liaison sans arête (ou surface de liaison arrondie) entre la face avant et cette paroi latérale orthogonale. On évite ainsi des contraintes qui auraient pu être produites dans la plaque en présence d'une arête entre la face avant et la paroi latérale.

La plaque peut être collée sur la face avant. Une couche de colle (ou de résine) est alors interposée entre la plaque et la face avant.

On peut prévoir également qu'une pièce intermédiaire soit interposée entre la plaque et la face avant.

Cette pièce intermédiaire peut comprend un cadre, sur lequel est collée la plaque, et/ou une partie de fixation sur la partie avant de la pièce de structure.

Le cadre peut éventuellement avoir une surface supérieure à celle de la face avant, ce qui donne plus de souplesse dans la conception (en particulier dans le choix des dimensions de l'évidement susmentionné).

L'afficheur peut être en partie au moins collé sur la face arrière de la plaque.

L'afficheur peut comprendre un modulateur de lumière monté sur la face arrière de la plaque.

Le câble électrique susmentionné peut alors être relié au modulateur de lumière. Un tel câble électrique est par exemple un câble électrique d'alimentation et/ou de commande du modulateur de lumière.

L'afficheur peut également comprendre une unité d'illumination. Cette unité d'illumination peut être montée sur la pièce de structure susmentionnée. En variante, l'unité d'illumination pourrait être montée sur une pièce distincte, éventuellement fixée à la pièce de structure.

Dans l'exemple décrit dans la suite, la pièce de maintien susmentionnée (dont une patte de fixation coopère avec un élément de coopération formé dans l'évidement de la partie avant) est un cadre (par exemple métallique) de maintien de l'unité d'illumination.

Selon une autre possibilité de réalisation, l'afficheur peut comprendre une matrice d'éléments émetteurs de lumière. L'afficheur peut dans ce cas être monté sur la face arrière de la plaque.

La partie avant susmentionnée peut présenter une forme généralement rectangulaire encadrant l'afficheur. Par exemple, la partie avant peut être conformée de sorte que la face avant présente des régions latérales situées de part et d'autre de l'afficheur et au moins un bandeau transversal (s'étendant d'une région latérale à l'autre région latérale), voire deux bandeaux transversaux (s'étendant de part et d'autre de l'afficheur, chacun d'une région latérale à l'autre région latérale).

L'évidement susmentionné peut alors former une interruption d'un bandeau transversal (parmi ces bandeaux transversaux) et ainsi une rupture de continuité de la face avant au niveau de ce bandeau transversal.

La plaque est par exemple en verre. En variante, la plaque pourrait être réalisée en matière plastique.

Enfin, le dispositif d'affichage peut comprendre une matrice tactile interposée entre l'afficheur et la plaque. En variante, une telle matrice tactile pourrait être intégrée à l'afficheur (l'afficheur étant alors un afficheur dit *"tactile"*)*.*

Bien entendu, les différentes caractéristiques, variantes et formes de réalisation de l'invention peuvent être associées les unes avec les autres selon diverses combinaisons dans la mesure où elles ne sont pas incompatibles ou exclusives les unes des autres.

De plus, diverses autres caractéristiques de l'invention ressortent de la description annexée effectuée en référence aux dessins qui illustrent des formes, non limitatives, de réalisation de l'invention et où :
[Fig. 1] représente une première vue en coupe d'un dispositif d'affichage conforme à l'invention ;
[Fig. 2] représente une seconde vue en coupe (dans le plan A-A visible en figure 1) du dispositif d'affichage de la figure 1 ;
[Fig. 3] représente une troisième vue en coupe (dans le plan B-B visible en figure 1) du dispositif d'affichage de la figure 1 ;
[Fig. 4] représente une vue de détail du dispositif d'affichage de la figure 1 ;
[Fig. 5] représente une variante de réalisation d'une pièce de structure d'un tel dispositif d'affichage ;
[Fig. 6] représente une variante de réalisation dans laquelle le dispositif d'affichage comprend une pièce intermédiaire ;
[Fig. 7] représente une autre variante de réalisation dans laquelle le dispositif d'affichage comprend une pièce intermédiaire ;
[Fig. 8] est une vue en coupe d'un tel dispositif d'affichage comprenant une pièce intermédiaire ; et
[Fig. 9] représente une vue en coupe du dispositif d'affichage de la figure 1.

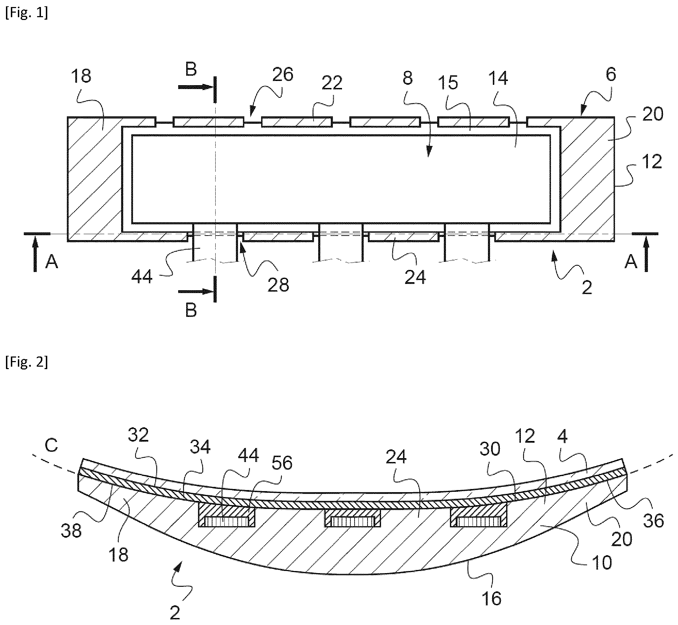

Les figures 1 à 4 et 9 représentent un dispositif d'affichage 2 comprenant une plaque 4 au moins partiellement transparente (ou vitre), une pièce de structure 6 et un afficheur 8.

Comme bien visible sur la figure 2, la pièce de structure 6 comprend une partie arrière (ou socle) 10 et une partie avant 12 s'étendant en direction de la plaque 4 à partir de la partie arrière 10.

La pièce de structure 6 est par exemple réalisée en métal (ici en magnésium ou alliage à base de magnésium, ou en variante en aluminium ou alliage à base d'aluminium). La pièce de structure 6 peut ainsi notamment participer à l'évacuation de la chaleur produite par l'afficheur 8.

Comme bien visible en figure 1, la partie avant 12 présente une forme généralement rectangulaire de telle sorte que cette partie avant 12 encadre l'afficheur 8, ici un modulateur de lumière 14 de l'afficheur 8.

La partie arrière (ou socle) 10 comprend ici en outre une paroi de fond 16 de sorte que la partie arrière 10 définit un logement pour l'afficheur 8.

En variante toutefois, le fond du logement accueillant l'afficheur 8 pourrait être réalisé au moyen d'une pièce complémentaire. Dans ce cas, la partie arrière 10 est dépourvu de paroi de fond et présente donc la forme générale d'un cadre.

La partie avant 12 de la pièce de structure 6 comprend deux extensions latérales 18, 20 situées de part et d'autre (ici horizontalement, c'est-à-dire respectivement à gauche et à droite) de l'afficheur 8 (ici du modulateur de lumière 14).

La partie avant 12 de la pièce de structure 6 comprend également deux murets 22, 24 situées de part et d'autre (ici verticalement, c'est-à-dire respectivement au-dessus et au-dessous) de l'afficheur 8 (ici du modulateur de lumière 14).

Chaque muret 22, 24 s'étend entre les deux extensions latérales 18, 20, ici d'une extension latérale 18 à l'autre extension latérale 20.

Chaque muret 22, 24 présente au moins un évidement, ici une pluralité d'évidements 26, 28. Dans le mode de réalisation décrit ici, la partie avant 12 présente une forme crénelée (ici en vue de dessus ou en vue de dessous) du fait de la présence de ces évidements 26, 28. Ainsi, la partie avant 14 définit au moins un créneau (ici une pluralité de créneaux) en section dans un plan (ici horizontal) perpendiculaire au plan moyen d'extension de l'afficheur 8. Autrement dit, chaque muret 22, 24 comporte une pluralité de dents séparées (deux à deux) par un évidement 26, 28.

Pour chaque muret 22, 24, le ratio entre longueur de muret non-évidée et longueur de muret évidée est par exemple compris entre 20 et 0,5, de préférence entre 4 et 10.

La partie avant 12 présente une face avant 30 (c'est-à-dire une surface externe tournée en direction de la plaque 4) qui s'étend à une distance constante d'une face arrière 32 de la plaque 4 de manière à former une surface d'appui pour la plaque 4.

Dans le mode de réalisation décrit ici, seule une couche de colle 34 est interposée entre la face avant 30 de la partie avant 12 et la face arrière 32 de la plaque 4, de façon à réaliser le montage de la plaque 4 sur cette face avant 30 par collage.

La face avant 30 comporte ainsi des régions latérales 36, 38 formées par les surfaces externes respectives (tournées vers la plaque 4) des extensions latérales 18, 20 et deux bandeaux transversaux formées par les surfaces externes respectives (tournées vers la plaque 4) des murets 22, 24.

Chaque bandeau transversal est toutefois interrompu (ici en plusieurs endroits) du fait de la présence des évidements 26, 28. Autrement dit, chaque bandeau transversal présente (ici en plusieurs endroits) une rupture de continuité de la face avant 30.

Chaque évidement 26, 28 forme ainsi un passage entre la partie arrière (ou socle) 10 et la plaque 4.

Dans l'exemple décrit, comme visible sur la figure 2, la plaque 4 recouvre toute la façade du dispositif d'affichage 2.

La plaque 4 est par exemple réalisée en verre. En variante toutefois, la plaque 4 pourrait être réalisée en matière plastique, par exemple du poly(méthacrylate de méthyle) ou du polycarbonate ou une combinaison de ces deux matières.

Dans le mode de réalisation décrit ici, la plaque 4 est courbe (avec une courbure dans un plan perpendiculaire au plan moyen d'extension de l'afficheur 8) et la face avant 30 est inscrite dans un cylindre C. L'axe de ce cylindre C est ici perpendiculaire à une normale au plan moyen d'extension de l'afficheur 8. Dans le mode de réalisation décrit, l'axe du cylindre C est vertical, c'est-à-dire ici perpendiculaire à la direction moyenne (ici horizontale) de plus grande extension de la plaque 4.

La plaque 4 est par exemple formée à force (étape de conformage), puis collée sur la face avant 30.

Le rayon de courbure de la face avant 30 (c'est-à-dire le rayon du cylindre C) est par exemple compris entre 1 m et 10 m. Dans d'autres modes de réalisation, notamment lorsque des matières plastiques sont utilisées pour la fabrication de la plaque 4 et/ou de l'afficheur 8, le rayon de courbure de la face avant 30 peut être très faible : ce rayon de courbure peut être compris entre 3 cm et 50 cm.

En variante, la plaque pourrait être plane.

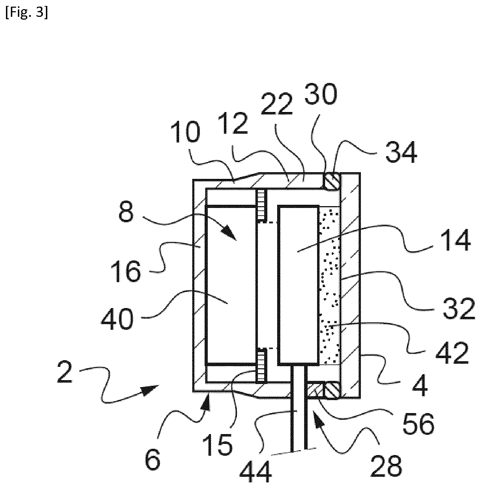

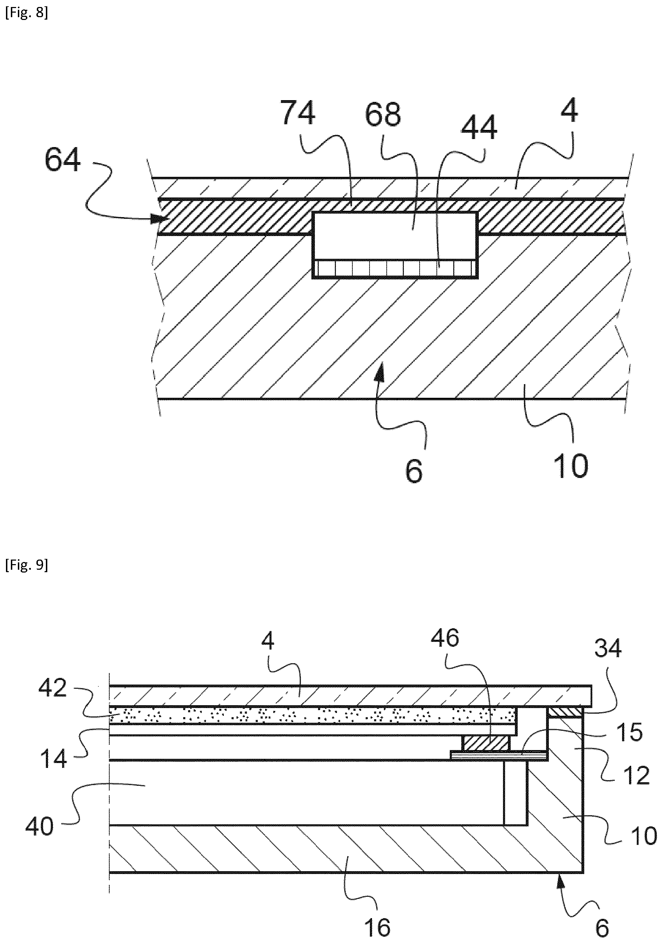

Dans l'exemple décrit ici, l'afficheur 8 comprend le modulateur de lumière 14 déjà mentionné et une unité d'illumination 40 produisant un faisceau lumineux en direction du modulateur de lumière 14 (pour rétroéclairage du modulateur de lumière 14). Le dispositif d'affichage 2 comprend ici en outre un cadre 15 (par exemple métallique, réalisé ici au moyen d'une tôle) formant pièce de maintien de l'unité d'illumination 40, comme visible en particulier sur les figures 3 et 9.

Le modulateur de lumière 14 (par exemple une dalle TFT LCD pour *"Thin-Film Transistor Liquid Crystal Display"*) comprend une matrice d'éléments (non représentée) dont la transmittance peut être commandée de sorte que chaque élément transmet (en direction de la plaque 4) une proportion commandable du faisceau lumineux reçu de l'unité d'illumination 40, ce qui permet de générer l'image à afficher.

Dans le cas susmentionné d'une dalle TFT LCD par exemple, le modulateur de lumière 14 comprend au moins un polariseur (non représenté). Dans ce cas en effet, le modulateur de lumière 14 comprend une matrice de cellules à cristaux liquides qui affectent chacun de manière commandable la polarisation de la lumière incidente (produite par l'unité d'illumination 40). Ainsi, la présence du polariseur susmentionné permet d'obtenir en sortie une quantité de lumière qui dépend de la polarisation impartie par la cellule concerné et qui est donc ajustable par commande de cette cellule.

L'unité d'illumination 40 est par exemple montée sur la pièce de structure 6 (dans le logement susmentionné). Dans l'exemple décrit ici, l'unité d'illumination 40 est reçue entre la paroi de fond 16 de la partie arrière (ou socle) 10 et la pièce de maintien (cadre métallique) 15, comme bien visible sur les figures 3 et 9. En variante toutefois, l'unité d'illumination 40 pourrait être montée sur une pièce distincte de la pièce de structure 6, cette pièce distincte pouvant par exemple être quant à elle fixée à la pièce de structure 6.

Dans l'exemple décrit, le modulateur de lumière 14 est collé sur plaque (au moyen d'une colle optique 42), précisément ici sur la face arrière 32 de la plaque 4.

En variante, l'afficheur 8 pourrait être réalisé au moyen d'une matrice d'éléments émetteurs de lumière (par exemple selon la technologie OLED (pour *"Organic Light Emitting Diode"*)*.* Dans ce cas, l'afficheur 8 dans son ensemble peut être collé sur la plaque 4.

Comme visible sur la figure 9, un joint souple 46 (tel qu'un joint en mousse) est ici interposé entre le cadre métallique 15 et le modulateur de lumière 14 (par exemple sur tout le pourtour du modulateur de lumière 14).

Selon une possibilité de réalisation, une matrice de détecteurs (par exemple capacitifs) peut être interposée entre l'afficheur 8 et la plaque 4 (ici par exemple collée entre le modulateur de lumière 14 et la plaque 4), afin de former un dispositif d'affichage tactile. En variante, une telle matrice de détecteurs pourrait être intégrée au modulateur de lumière 14.

Le dispositif d'affichage 2 comprend au moins un câble électrique 44 (ici une pluralité de câbles électriques) pour relier (électriquement) l'afficheur 8 à des circuits électriques d'alimentation et/ou de commande (non représentés).

Chaque câble électrique 44 peut être par exemple un câble électrique en nappe. Chaque câble électrique 44 peut porter par exemple des signaux d'alimentation et/ou de commande destinés à l'afficheur 8 (ici au modulateur de lumière 14), et/ou des signaux de détection et/ou de mesure produits par l'afficheur 8 (ou par la matrice de détecteurs susmentionnée).

Dans l'exemple décrit ici, chaque câble électrique 44 relie le modulateur de lumière 14 à des circuits électriques d'alimentation et/ou de commande.

Au moins un des câbles électriques 44 s'étend à travers le passage formé par un évidement 28 entre la partie arrière (ou socle) 10 et la plaque 4.

Ce câble électrique 44 traverse ainsi la paroi de la pièce de structure 6 au plus près de l'afficheur 8 (ici précisément au plus près du modulateur de lumière 14, qui est dans l'exemple décrit collé sur la face arrière 32 de la plaque 4 comme déjà indiqué). On obtient ainsi un agencement simple et peu encombrant des différents éléments du système.

Comme visible en figure 2, on peut prévoir en outre que l'espace résiduel de l'évidement 28 (en présence du câble électrique 44, c'est-à-dire principalement l'espace entre le câble électrique 44 et la plaque 4) soit rempli par la colle 34 déposée entre la face avant 30 de la partie avant 12 et la face arrière 32 de la plaque 4, ainsi éventuellement que par une autre colle 56 déposée dans ce cas entre le câble électrique 44 et la colle 34, comme représenté par exemple en figure 2. On assure ainsi la fixation des câbles électriques 44 et on améliore la tenue mécanique de l'ensemble. (Par souci de clarté, la figure 1 est représentée sans montrer la colle présente dans les évidements 28.)

La pièce de structure 6 comprend par ailleurs des zones de fixation d'une pièce (telle qu'ici la pièce de maintien 15 susmentionnée ou, en variante, une autre pièce tel qu'un cache, monté par exemple à l'arrière de la pièce de structure 6) au niveau respectivement de certains des évidements 26, au niveau respectivement des évidements 26 formés dans le muret 22 situé au-dessus de l'afficheur 8 dans l'exempl représenté sur les figures.

De telles zones de fixation peuvent également être agencées dans le muret 24 (situé en-dessous de l'afficheur 8 en figure 1), mais n'ont pas été représentées dans les dessins par souci de simplification.

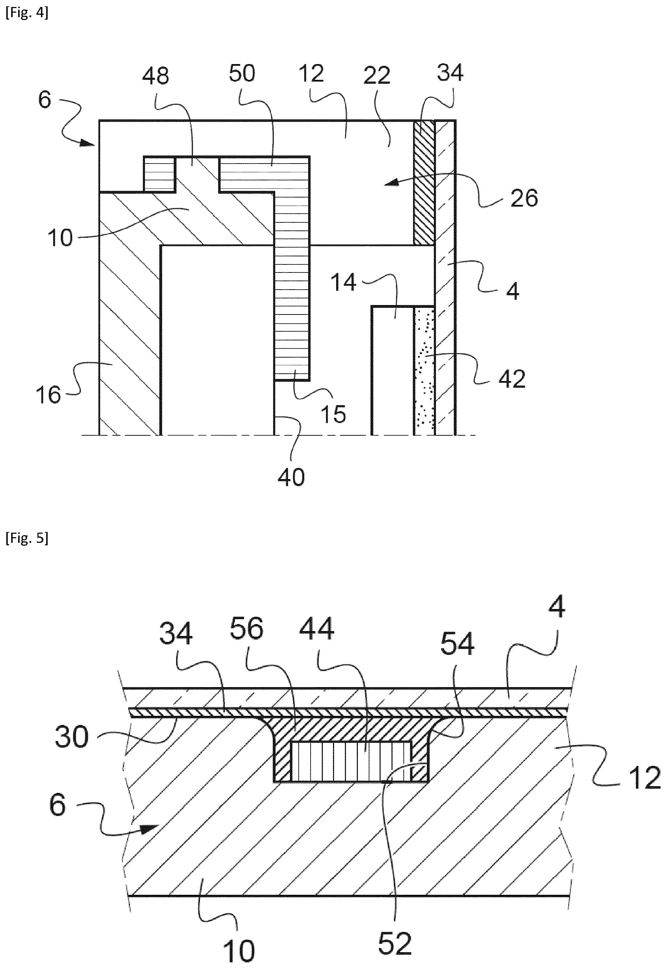

Une telle zone de fixation est représentée en figure 4.

Pour au moins une zone de fixation (ici pour chaque zone de fixation), la pièce de structure 6 porte, ici au niveau de la partie arrière 10, un téton 48 formé sur une partie de la pièce de structure 6 (ici sur une partie de la partie arrière 10) bordant l'évidement 26, et conçu pour coopérer (ici par encliquetage) avec une patte de fixation 50 solidaire de la pièce fixée, c'est-à-dire ici solidaire de la pièce de maintien (ou cadre métallique) 15. Dans l'exemple décrit ici, la patte de fixation 50 est formée d'une pièce avec la pièce de maintien (ou cadre métallique) 15.

Comme visible sur la figure 4, la patte de fixation 50 s'étend en partie à travers le passage formé (par l'évidement 26) entre la plaque 4 et la partie arrière 10, et peut ainsi atteindre (à partir de la pièce de maintien 15 située dans le logement formé par la pièce de structure 6 et accueillant l'afficheur 8) le téton 48 formé à l'extérieur de la pièce de structure 6.

La figure 5 représente une variante de réalisation pour partie avant 12 de la pièce de structure 6.

Comme visible sur cette figure 5, le passage formé par un évidement 26, 28 (ou cet évidement lui-même) est notamment défini par une paroi latérale 52 orthogonale à la face avant 30.

Selon la présente variante, la partie avant 12 présente une surface de liaison 54 sans arête entre la face avant 30 et cette paroi latérale 52.

Cette surface de liaison présente par exemple un rayon de courbure compris entre 0,1 mm et 20 mm.

Une telle surface de liaison 54 arrondie permet de limiter les contraintes générées à l'intérieur de la plaque 4.

Comme visible sur la figure 5, les deux parois latérales orthogonales à la face avant 30 et définissant l'évidement 26, 28 concerné peuvent chacune être reliées à la face avant 30 par une telle surface de liaison sans arête (ou surface de liaison arrondie).

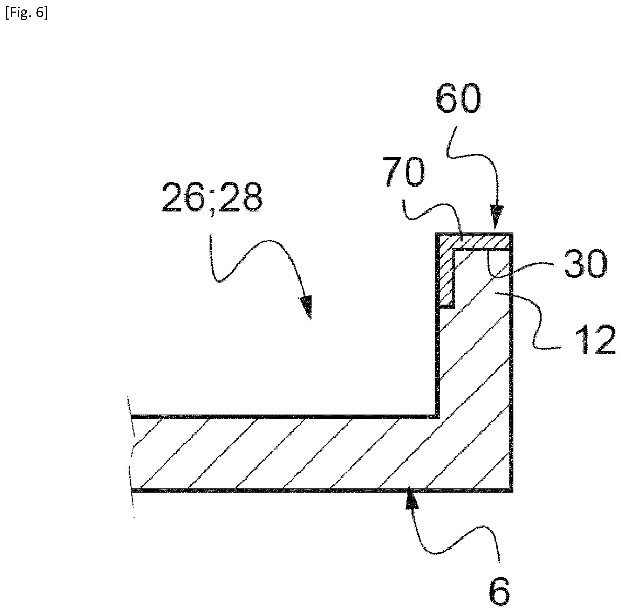

Les figures 6 à 8 représentent des variantes de réalisation dans lesquelles une pièce intermédiaire 60, 62, 64 est interposée entre la plaque 4 et la face avant 30 de la partie avant 12 de la pièce de structure 6.

La pièce intermédiaire 60, 62, 64 comprend notamment un cadre 70, 72, 74 interposé entre la face avant 30 et la plaque 4. La plaque 4 peut ainsi être fixée (par exemple collée) sur ce cadre 70, 72, 74.

La pièce intermédiaire 60, 62, 64 peut être réalisée en métal ou en matière plastique, ce qui offre une souplesse de conception supplémentaire.

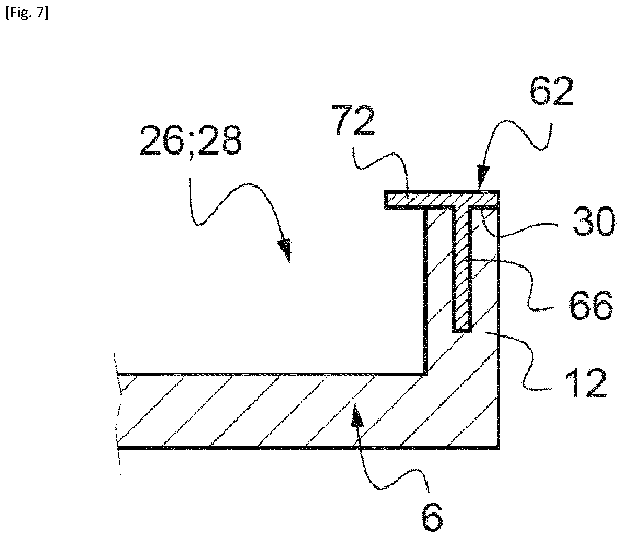

Comme visible sur la figure 7, le cadre 72 peut présenter une surface plus importante que celle de la face avant 30 (par exemple du fait que le cadre 72 déborde la face avant 30 à l'avant de l'évidement 26, 28 concerné), ce qui peut ainsi permettre une meilleure tenue de la plaque 4. En outre, cette surface plus importante est obtenue tout en conservant une souplesse pour le choix de la dimension de l'évidement 26, 28, par exemple pour permettre le passage des câbles électriques 44 comme expliqué précédemment.

Selon un premier mode de réalisation (représenté sur la figure 6), la pièce intermédiaire 60 a une forme complémentaire (ici une forme de L en section) d'une partie de la pièce de structure 6 (ici d'une partie de la partie avant 12). La pièce intermédiaire 60 est alors insérée et/ou collée contre la pièce de structure 6.

Selon un second mode de réalisation (représentée sur la figure 7), la pièce intermédiaire 62 comprend une partie (par exemple une tige 66) s'étendant vers l'arrière (i.e. en direction de la pièce de structure 6) et permettant la fixation de la pièce intermédiaire sur la partie avant 12 de la pièce de structure 6 (par exemple par insertion à force, possiblement dans une ouverture ménagée dans la pièce de structure 6, ou par collage). La pièce intermédiaire 62 présente alors une forme de T en section.

Selon une possibilité de réalisation représentée en figure 8, l'espace résiduel de l'évidement 28 concerné est rempli d'une colle ou d'une résine 68 pour rigidification de l'ensemble. Cet espace résiduel peut être formé entre la pièce intermédiaire 64 (précisément le cadre 74 de cette pièce intermédiaire 64) et la pièce de structure 6. Selon une autre possibilité, lorsqu'un câble électrique 44 est reçu dans l'évidement 28 concerné comme représenté en figure 8, cet espace résiduel peut être formé entre la pièce intermédiaire 64 (précisément le cadre 74 de cette pièce intermédiaire 64) et le câble électrique 44.

## Revendications

1. Dispositif d'affichage (2) comprenant :
- un afficheur (8) ;
- une plaque (4) au moins partiellement transparente ; et
- une pièce de structure (6) comprenant une partie arrière (10) et une partie avant (12) s'étendant vers la plaque (4) à partir de la partie arrière (10) en encadrant l'afficheur (8), la partie avant (12) présentant une face avant (30) s'étendant à une distance constante d'une face arrière (32) de la plaque (4) de manière à former une surface d'appui pour la plaque (4),
**caractérisé en ce que** la partie avant (12) présente au moins un évidement (26 ; 28) agencé pour former un passage entre la partie arrière (10) et la plaque (4).

2. Dispositif d'affichage selon la revendication 1, dans lequel un câble électrique (44) relié à l'afficheur (8) est agencé dans le passage.

3. Dispositif d'affichage selon la revendication 2, dans lequel un espace résiduel de l'évidement (28) est rempli de colle (34, 56).

4. Dispositif d'affichage selon la revendication 1, dans lequel l'évidement (26) accueille au moins un élément (48) de coopération avec une patte de fixation (50) d'une pièce supplémentaire.

5. Dispositif d'affichage selon la revendication 4, dans lequel la pièce supplémentaire est une pièce (15) de maintien d'un élément (40) de l'afficheur (8).

6. Dispositif d'affichage selon l'une des revendications 1 à 5, dans lequel la plaque (4) est courbe et dans lequel ladite face avant (30) est inscrite dans un cylindre (C).

7. Dispositif d'affichage selon l'une des revendications 1 à 6, dans lequel le passage est défini par une paroi latérale (52) orthogonale à la face avant (30) et la partie avant (12) présente une surface de liaison sans arête entre la face avant (30) et ladite paroi latérale orthogonale (52).

8. Dispositif d'affichage selon l'une des revendications 1 à 7, dans lequel la plaque (4) est collée sur ladite face avant (30).

9. Dispositif d'affichage selon l'une des revendications 1 à 8, dans lequel une pièce intermédiaire (60 ; 62 ; 64) soit interposée entre la plaque (4) et la face avant (30).

10. Dispositif d'affichage selon la revendication 9, dans lequel la pièce intermédiaire (60 ; 62 ; 64) comprend un cadre (70 ; 72 ; 74) sur lequel est collée la plaque (4).

11. Dispositif d'affichage selon la revendication 9 ou 10, dans lequel la pièce intermédiaire comprend une partie (66) de fixation sur la partie avant (12) de la pièce de structure (6).

12. Dispositif d'affichage selon l'une des revendications 1 à 11, dans lequel la partie avant (12) comporte une pluralité d'évidements distincts formant chacun un passage entre la partie arrière (10) et la plaque (4).

13. Dispositif d'affichage selon l'une des revendications 1 à 12, dans lequel l'afficheur (8) est en partie au moins collé sur ladite face arrière (32).

14. Dispositif d'affichage selon l'une des revendications 1 à 13, dans lequel l'afficheur (8) comprend un modulateur de lumière (14) monté sur ladite face arrière (32).

15. Dispositif d'affichage selon la revendication 14 prise dans la dépendance directe ou indirecte de la revendication 2, dans lequel le câble électrique (44) est relié au modulateur de lumière (14).

16. Dispositif d'affichage selon l'une des revendications 1 à 15, dans lequel l'afficheur comprend une unité d'illumination (40) montée sur la pièce de structure (6).

17. Dispositif d'affichage selon l'une des revendications 1 à 16, dans lequel ladite partie avant (12) présente une forme généralement rectangulaire encadrant l'afficheur (8).

18. Dispositif d'affichage selon l'une des revendications 1 à 17, dans lequel la partie avant (12) est conformée de sorte que la face avant (30) présente des régions latérales (36, 38) situées de part et d'autre de l'afficheur et au moins un bandeau transversal.

19. Dispositif d'affichage selon la revendication 18, dans lequel ledit évidement forme une interruption du bandeau transversal.

20. Dispositif d'affichage selon l'une des revendications 1 à 19, dans lequel la plaque est en verre.

21. Dispositif d'affichage selon l'une des revendications 1 à 20, comprenant une matrice tactile interposée entre l'afficheur (8) et la plaque (4).

## Patentansprüche

1. Anzeigevorrichtung (2), die Folgendes aufweist:
- eine Anzeige (8);
- eine zumindest teilweise transparente Platte (4) und
- ein Strukturteil (6) mit einem hinteren Abschnitt (10) und einem vorderen Abschnitt (12), der sich von dem hinteren Abschnitt (10) in Richtung der Platte (4) erstreckt und die Anzeige (8) einrahmt, wobei der vordere Abschnitt (12) eine Vorderseite (30) aufweist, die sich in einem konstanten Abstand von einer Rückseite (32) der Platte (4) erstreckt, um eine Auflagefläche für die Platte (4) zu bilden,
**dadurch gekennzeichnet, dass** der vordere Abschnitt (12) mindestens eine Aussparung (26; 28) aufweist, die so angeordnet ist, dass sie einen Durchgang zwischen dem hinteren Abschnitt (10) und der Platte (4) bildet.

2. Anzeigevorrichtung nach Anspruch 1, wobei ein mit der Anzeige (8) verbundenes elektrisches Kabel (44) in dem Durchgang angeordnet ist.

3. Anzeigevorrichtung nach Anspruch 2, wobei ein Restraum der Aussparung (28) mit Klebstoff (34, 56) gefüllt ist.

4. Anzeigevorrichtung nach Anspruch 1, wobei die Aussparung (26) mindestens ein Element (48) zum Zusammenwirken mit einer Befestigungslasche (50) eines zusätzlichen Teils aufnimmt.

5. Anzeigevorrichtung nach Anspruch 4, wobei das zusätzliche Teil ein Teil (15) zum Halten eines Elements (40) der Anzeige (8) ist.

6. Anzeigevorrichtung nach einem der Ansprüche 1 bis 5, wobei die Platte (4) gekrümmt ist und wobei die Vorderseite (30) in einen Zylinder (C) eingeschrieben ist.

7. Anzeigevorrichtung nach einem der Ansprüche 1 bis 6, wobei der Durchgang durch eine Seitenwand (52), die orthogonal zur Vorderseite (30) verläuft, definiert ist und der vordere Abschnitt (12) eine kantenlose Verbindungsfläche zwischen der Vorderseite (30) und der orthogonalen Seitenwand (52) aufweist.

8. Anzeigevorrichtung nach einem der Ansprüche 1 bis 7, wobei die Platte (4) auf die Vorderseite (30) geklebt ist.

9. Anzeigevorrichtung nach einem der Ansprüche 1 bis 8, wobei ein Zwischenstück (60; 62; 64) zwischen der Platte (4) und der Vorderseite (30) eingefügt ist.

10. Anzeigevorrichtung nach Anspruch 9, wobei das Zwischenstück (60; 62; 64) einen Rahmen (70; 72; 74) aufweist, auf den die Platte (4) geklebt ist.

11. Anzeigevorrichtung nach Anspruch 9 oder 10, wobei das Zwischenstück einen Abschnitt (66) zur Befestigung an dem vorderen Abschnitt (12) des Strukturteils (6) aufweist.

12. Anzeigevorrichtung nach einem der Ansprüche 1 bis 11, wobei der vordere Abschnitt (12) eine Vielzahl von unterschiedlichen Aussparungen aufweist, die jeweils einen Durchgang zwischen dem hinteren Abschnitt (10) und der Platte (4) bilden.

13. Anzeigevorrichtung nach einem der Ansprüche 1 bis 12, wobei die Anzeige (8) zumindest teilweise auf die Rückseite (32) geklebt ist.

14. Anzeigevorrichtung nach einem der Ansprüche 1 bis 13, wobei die Anzeige (8) einen Lichtmodulator (14) aufweist, der auf der Rückseite (32) angebracht ist.

15. Anzeigevorrichtung nach Anspruch 14, in direkter oder indirekter Abhängigkeit von Anspruch 2 genommen, wobei das elektrische Kabel (44) mit dem Lichtmodulator (14) verbunden ist.

16. Anzeigevorrichtung nach einem der Ansprüche 1 bis 15, wobei die Anzeige eine Beleuchtungseinheit (40) aufweist, die an dem Strukturteil (6) angebracht ist.

17. Anzeigevorrichtung nach einem der Ansprüche 1 bis 16, wobei der vordere Abschnitt (12) eine allgemein rechteckige Form aufweist, die die Anzeige (8) einrahmt.

18. Anzeigevorrichtung nach einem der Ansprüche 1 bis 17, wobei der vordere Abschnitt (12) so geformt ist, dass die Vorderseite (30) auf beiden Seiten der Anzeige befindliche seitliche Bereiche (36, 38) und mindestens einen Querstreifen aufweist.

19. Anzeigevorrichtung nach Anspruch 18, wobei die Aussparung eine Unterbrechung des Querstreifens bildet.

20. Anzeigevorrichtung nach einem der Ansprüche 1 bis 19, wobei die Platte aus Glas besteht.

21. Anzeigevorrichtung nach einem der Ansprüche 1 bis 20 mit einer zwischen der Anzeige (8) und der Platte (4) liegenden taktilen Matrix.

## Claims

1. Display device (2) comprising:
- a display (8);
- an at least partially transparent sheet (4); and
- a structural component (6) comprising a rear part (10) and a front part (12) extending toward the sheet (4) from the rear part (10) and framing the display (8), the front part (12) having a front face (30) extending at a constant distance from a rear face (32) of the sheet (4) so as to form a bearing surface supporting the sheet (4),
**characterized in that** the front part (12) has at least one opening (26; 28) designed to form a passage between the rear part (10) and the sheet (4).

2. Display device according to Claim 1, wherein an electric cable (44) connected to the display (8) is arranged in the passage.

3. Display device according to Claim 2, wherein the residual space in the opening (28) is filled with adhesive (34, 56).

4. Display device according to Claim 1, wherein the opening (26) accommodates at least one element (48) for collaborating with a fixing tab (50) belonging to an additional component.

5. Display device according to Claim 4, wherein the additional component is a retaining component (15) holding an element (40) of the display (8).

6. Display device according to one of Claims 1 to 5, wherein the sheet (4) is curved and wherein said front face (30) is inscribed in a cylinder (C).

7. Display device according to one of Claims 1 to 6, wherein the passage is defined by a lateral wall (52) orthogonal to the front face (30) and the front part (12) has a connecting surface with no sharp corners between the front face (30) and said orthogonal lateral wall (52).

8. Display device according to one of Claims 1 to 7, wherein the sheet (4) is bonded to said front face (30).

9. Display device according to one of Claims 1 to 8, wherein an intermediate component (60; 62; 64) is interposed between the sheet (4) and the front face (30).

10. Display device according to Claim 9, wherein the intermediate component (60; 62; 64) comprises a frame (70; 72; 74) onto which the sheet (4) is bonded.

11. Display device according to Claim 9 or 10, wherein the intermediate component comprises a part (66) for fixing to the front part (12) of the structural component (6).

12. Display device according to one of Claims 1 to 11, wherein the front part (12) has a plurality of distinct openings each forming a passage between the rear part (10) and the sheet (4).

13. Display device according to one of Claims 1 to 12, wherein the display (8) is at least partially bonded to said rear face (32).

14. Display device according to one of Claims 1 to 13, wherein the display (8) comprises a light modulator (14) mounted on said rear face (32).

15. Display device according to Claim 14 considered in direct or indirect dependence on Claim 2, wherein the electric cable (44) is connected to the light modulator (14).

16. Display device according to one of Claims 1 to 15, wherein the display comprises an illumination unit (40) mounted on the structural component (6).

17. Display device according to one of Claims 1 to 16, wherein said front part (12) is of rectangular overall shape framing the display (8).

18. Display device according to one of Claims 1 to 17, wherein the front part (12) is configured such that the front face (30) has lateral regions (36, 38) situated on each side of the display, and at least one transverse band.

19. Display device according to Claim 18, wherein said opening forms an interruption of the transverse band.

20. Display device according to one of Claims 1 to 19, wherein the sheet is made of glass.

21. Display device according to one of Claims 1 to 20, comprising a touch-sensitive matrix interposed between the display (8) and the sheet (4).
